# EUROPEAN PATENT APPLICATION

(11) **EP 4 830 863 A1**
(43) Date of publication of application: **28.10.2026**
(21) Application number: 24907248.9
(22) Date of filing: 10.12.2024
(51) Int. Cl.: B23K 26/34, B22F 10/28, B22F 12/44, B23K 26/21, B23K 26/064, B23K 26/073, B23K 26/082, B29C 64/153, B29C 64/268, B33Y 30/00, G03F 7/20

(54) **OPTICAL DEVICE AND THREE-DIMENSIONAL SHAPING DEVICE**

(30) Priority: 21.12.2023 JP 2023215365
(71) Applicant: SCREEN Holdings Co., Ltd., Kyoto-shi, Kyoto 602-8585 (JP)
(72) Inventor: MIZUNO, Hirofumi, Kyoto-shi, Kyoto 602-8585 (JP); HASHIMOTO, Yoshimi, Kyoto-shi, Kyoto 602-8585 (JP)
(74) Representative: Goddar, Heinz J.
(86) International application number: PCT/JP2024/043592
(87) International publication number: WO 2025/134863

(57) **Abstract**

A second optical system (23) of an optical apparatus includes a short axis side light shielding part (236), a third lens (233), a long axis side light shielding part (235), a fourth lens (234), and a scanning mechanism (237). The long axis side light shielding part (235) is disposed at a condensing position on a long axis side of a modulated beam (L33) by the third lens (233). The long axis side light shielding part (235) blocks a non-zero-order diffracted beam on the long axis side of the modulated beam (L33). The scanning mechanism (237) is disposed between the third lens (233) and the fourth lens (234), to be adjacent to the long axis side light shielding part (235). The scanning mechanism (237) scans the modulated beam (L33) before entering the long axis side light shielding part (235) or the modulated beam (L33) having passed through the long axis side light shielding part (235) in at least one of a long axis direction and a short axis direction. It is thereby possible to simplify a structure of the optical apparatus (12).

## Description

### TECHNICAL FIELD

The present invention relates to an optical apparatus which emits a spot light array onto a target object, and a three-dimensional modeling apparatus which includes the optical apparatus.

### CROSS-REFERENCE TO RELATED APPLICATIONS

The present application claims the benefit of priority to Japanese Patent Application No. 2023-215365 filed on December 21, 2023, the content of which is incorporated herein by reference in its entirety.

### BACKGROUND ART

In recent years, an SLS (Selective Laser Sintering) type three-dimensional modeling apparatus has been used, which emits a modulated laser beam to a modeling material such as metal powder, resin powder, or the like and sinters the modeling material, to thereby perform three-dimensional modeling.

In a three-dimensional model manufacturing apparatus disclosed in Japanese Patent Application Laid Open Gazette No. 2011-127192 (Document 1), for example, a single spot laser beam is emitted and scanned on an upper surface of a powder layer by a laser beam irradiation unit 61 provided above the powder layer. The laser beam irradiation unit 61 includes an optical fiber connector 83 connected to a laser oscillator, a collimator lens 85 for converting a laser beam emitted from the optical fiber connector 83 into parallel rays of light, a galvanometer optical scanner 89 which is a scanning mechanism for two-dimensionally scanning the laser beam having passed through the collimator lens 85, and an Fθ lens 99 for condensing the laser beam scanned by the galvanometer optical scanner 89 and emitting the laser beam onto the powder layer.

Further, in the three-dimensional modeling apparatus, in order to increase productivity, it is considered to form a linear pattern light by using an optical modulator and then emit a plurality of spot lights (spot beams) onto a modeling material at the same time (in other words, emit a spot light array), to thereby scan the light.

In the three-dimensional modeling apparatus for emitting a spot light array, in order to increase the power density (i.e., the light intensity per unit area) of the laser beam to be emitted onto the modeling material, light having high power density is emitted to the optical modulator for forming the linear pattern light. At that time, when the linear laser beam whose intensity distribution is a Gaussian distribution is emitted to the optical modulator, the peak intensity (i.e., maximum intensity) on a modulation surface of the optical modulator becomes excessively high, and this causes a possibility that the optical modulator may be damaged.

Then, in a three-dimensional modeling apparatus disclosed in Japanese Patent Application Laid Open Gazette No. 2021-165769 (Document 2), it is suggested to increase the amount of light to be inputted to an optical modulator without damaging the optical modulator by shaping the intensity distribution of a linear laser beam incident onto the optical modulator to be flat by using a top-hat beam shaper.

In the three-dimensional modeling apparatus disclosed in Document 2, in order to achieve the above-described object, an illumination optical system and a projection optical system each include relatively many lenses and the like. Further, though not described in detail in Document 2, a scanning part of the three-dimensional modeling apparatus needs to include a plurality of optical elements (i.e., a collimator lens, a galvano scanner, an Fθ lens, and the like), substantially like in Document 1, so as to image the linear laser beam having passed through the projection optical system on an upper surface of the modeling material (i.e., a scanned surface) and scan the linear laser beam thereon. For this reason, in the three-dimensional modeling apparatus, there is a limit to simplification of a structure of an optical apparatus which guides the laser beam emitted from a light source to the scanned surface of the modeling material, to thereby scan the laser beam thereon.

### SUMMARY OF THE INVENTION

The present invention is intended for a technique for emitting a spot light array onto a target object to scan the spot light array thereon, and it is an object of the present invention to simplify a structure of an optical apparatus.

A first aspect of the present invention is intended for an optical apparatus for emitting a spot light array onto a target object to scan the spot light array thereon, and the optical apparatus includes a first optical system for shaping a laser beam into a shaped beam which is long in a long axis direction, an optical modulator for modulating the shaped beam into a modulated beam having a pattern in the long axis direction, and a second optical system for guiding the modulated beam onto a scanned surface of a target object, to thereby form a spot light array extending in the long axis direction on the scanned surface and scan the spot light array on the scanned surface. In the optical apparatus according to the first aspect of the present invention, the second optical system includes a short axis side light shielding part disposed at a condensing position on a short axis side of the modulated beam, for blocking a non-zero-order diffracted beam on the short axis side of the modulated beam, a first projection optical element disposed between the short axis side light shielding part and the scanned surface, for condensing the modulated beam in the long axis direction, a long axis side light shielding part disposed at a condensing position on a long axis side of the modulated beam from the first projection optical element, between the first projection optical element and the scanned surface, for blocking a non-zero-order diffracted beam on the long axis side of the modulated beam, a second projection optical element disposed between the long axis side light shielding part and the scanned surface, for converging the modulated beam having passed through the long axis side light shielding part in the short axis direction and condensing the modulated beam on the scanned surface, to thereby form a spot light array on the scanned surface, and a scanning mechanism disposed between the first projection optical element and the second projection optical element, to be adjacent to the long axis side light shielding part, for scanning the modulated beam before entering the long axis side light shielding part or the modulated beam having passed through the long axis side light shielding part in at least one of the long axis direction and the short axis direction. A modulation surface of the optical modulator and the scanned surface are optically conjugated with respect to the long axis direction by the second optical system.

According to the present invention, it is possible to simplify a structure of the optical apparatus.

A second aspect of the present invention is intended for the optical apparatus of the first aspect, and in the optical apparatus according to the second aspect of the present invention, the scanning mechanism is a galvano scanner for changing a reflection direction of the modulated beam.

A third aspect of the present invention is intended for the optical apparatus of the second aspect, and in the optical apparatus according to the third aspect of the present invention, the galvano scanner includes a first galvanometer mirror disposed between the first projection optical element and the long axis side light shielding part to be adjacent to the long axis side light shielding part, for being rotated, to thereby change a reflection direction of the modulated beam in either one of the long axis direction and the short axis direction and a second galvanometer mirror disposed between the long axis side light shielding part and the second projection optical element to be adjacent to the long axis side light shielding part, for being rotated, to thereby change a reflection direction of the modulated beam in the other one of the long axis direction and the short axis direction.

A fourth aspect of the present invention is intended for the optical apparatus of the third aspect, and in the optical apparatus according to the fourth aspect of the present invention, the first galvanometer mirror changes a reflection direction of the modulated beam in the short axis direction.

A fifth aspect of the present invention is intended for the optical apparatus of the first aspect (or any one of the first to fourth aspects), and in the optical apparatus according to the fifth aspect of the present invention, the first optical system includes a beam shaper for converting an intensity distribution of the laser beam in the long axis direction from a Gaussian distribution, to thereby bring an intensity distribution of the shaped beam on the modulation surface in the long axis direction into a top hat distribution.

A sixth aspect of the present invention is intended for the optical apparatus of the fifth aspect, and in the optical apparatus according to the sixth aspect of the present invention, the beam shaper converts an intensity distribution of the laser beam in the short axis direction from a Gaussian distribution, to thereby also bring an intensity distribution of the shaped beam on the modulation surface in the short axis direction into a top hat distribution.

A seventh aspect of the present invention is intended for the optical apparatus of the first aspect (or any one of the first to sixth aspects), and in the optical apparatus according to the seventh aspect of the present invention, no optical element is disposed between the scanning mechanism and the long axis side light shielding part.

An eighth aspect of the present invention is intended for the optical apparatus of the first aspect (or any one of the first to seventh aspects), and in the optical apparatus according to the eighth aspect of the present invention, the optical modulator is a PLV (Planar Light Valve).

A ninth aspect of the present invention is intended for a three-dimensional modeling apparatus, and the three-dimensional modeling apparatus includes the optical apparatus of any one of the first to eighth aspects, a laser light source for emitting the laser beam to the optical apparatus, and a material holding part for holding a modeling material which is the target object to be irradiated with the modulated beam from the optical apparatus.

These and other objects, features, aspects and advantages of the present invention will become more apparent from the following detailed description of the present invention when taken in conjunction with the accompanying drawings.

### BRIEF DESCRIPTION OF DRAWINGS

FIG. 1 is a view showing a configuration of a three-dimensional modeling apparatus in accordance with a first preferred embodiment;
FIG. 2 is a view showing a structure of an optical modulator;
FIG. 3 is a view showing a configuration of the optical apparatus and an optical path in the optical apparatus;
FIG. 4 is another view showing the configuration of the optical apparatus and the optical path in the optical apparatus;
FIG. 5 is a perspective view showing a short axis side light shielding part; and
FIG. 6 is a perspective view showing a long axis side light shielding part;
FIG. 7 is a view showing a configuration of an optical apparatus and an optical path in the optical apparatus in accordance with a second preferred embodiment; and
FIG. 8 is another view showing the configuration of the optical apparatus and the optical path in the optical apparatus.

### DESCRIPTION OF EMBODIMENTS

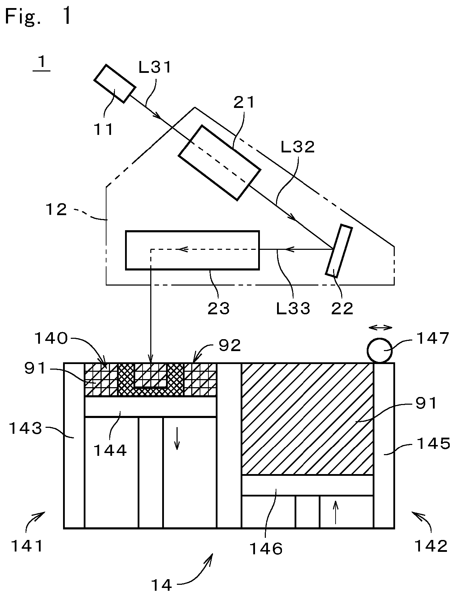

FIG. 1 is a view showing a configuration of a three-dimensional modeling apparatus 1 in accordance with the first preferred embodiment of the present invention. The three-dimensional modeling apparatus 1 is an SLS (Selective Laser Sintering) type three-dimensional modeling apparatus which emits a modulated laser beam to a powdery or pasty modeling material and sinters or melts the modeling material, to thereby perform three-dimensional modeling. The modeling material is, for example, a metal, engineering plastics, ceramics, a synthetic resin, or the like. The modeling material may contain a plurality of types of materials.

The three-dimensional modeling apparatus 1 includes a laser light source 11, an optical apparatus 12, and a material feeding mechanism 14. FIG. 1 shows a longitudinal section of the material feeding mechanism 14. In the three-dimensional modeling apparatus 1, a laser beam L31 emitted from the laser light source 11 is guided to the material feeding mechanism 14 by the optical apparatus 12 and scanned on a modeling material 91 inside a modeling space 140 of the material feeding mechanism 14. A portion of the modeling material 91 which is irradiated with the laser beam is sintered. Then, by repeating the feed of the modeling material 91 into the modeling space 140 and the scan of the laser beam on the modeling material 91, a three-dimensional model is formed. In FIG. 1, for easy understanding of this figure, constituent elements of the optical apparatus 12 are surrounded by a two-dot chain line.

In the three-dimensional modeling apparatus 1, the constituent elements such as the laser light source 11, the optical apparatus 12, the material feeding mechanism 14, and the like are controlled by a not-shown control part on the basis of design data (e.g., CAD data) or the like of a three-dimensional model to be produced. The control part is, for example, an ordinary computer including a processor, a memory, an input/output part, and a bus. Further, the constituent elements of the control part may be changed in various ways.

The laser light source 11 emits the laser beam L31 to the optical apparatus 12. The laser light source 11 is, for example, a fiber laser light source. The wavelength of the laser beam L31 is, for example, 1.070 µm. Further, the type of the laser light source 11 and the wavelength of the laser beam L31 may be changed in various ways.

The optical apparatus 12 modulates the laser beam L31 from the laser light source 11 into a modulated beam L33 and emits the modulated beam L33 onto an upper surface 92 (hereinafter, referred to as a "scanned surface 92") of the modeling material 91 inside the modeling space 140. On the scanned surface 92, a spot light array in which a plurality of spot lights are arranged substantially straight linearly is formed of the modulated beam L33 guided by the optical apparatus 12. Further, the optical apparatus 12 scans the spot light array on the scanned surface 92.

The optical apparatus 12 includes a first optical system 21, an optical modulator 22, and a second optical system 23. The first optical system 21 and the second optical system 23 each include a plurality of optical elements such as lenses or the like, as described later. The first optical system 21 is an illumination optical system which guides the laser beam L31 from the laser light source 11 to the optical modulator 22. The second optical system 23 is an optical system in which a scanning mechanism for scanning the modulated beam L33 on the scanned surface 92 is incorporated into a projection optical system which guides the modulated beam L33 from the optical modulator 22 onto the scanned surface 92 of the modeling material 91.

The first optical system 21 shapes the laser beam L31 from the laser light source 11 into a shaped beam L32 having a substantially rectangular shape which is long in one direction (hereinafter, referred to as a "long axis direction") and guides the shaped beam L32 to the optical modulator 22. In other words, the cross-sectional shape of the shaped beam L32 is a substantially rectangular shape which is long in the long axis direction and short in a short axis direction perpendicular to the long axis direction. The shaped beam L32 refers to a light beam until entering the optical modulator 22 after passing through the first optical system 21.

The long axis direction and the short axis direction described above are directions perpendicular to a traveling direction (i.e., an optical axis direction) of the shaped beam L32. Further, the cross-sectional shape of the shaped beam L32 is the shape of the shaped beam L32 on a plane perpendicular to the optical axis direction of the shaped beam L32. In the following description, the cross section of light refers to a cross section of the light on a plane perpendicular to the optical axis direction of the light, like the above-described one. The cross-sectional shape of the shaped beam L32 can be regarded to be a substantially straight linear shape extending in the long axis direction. The shape of an irradiation region of the shaped beam L32 on the optical modulator 22 is, for example, a substantially rectangular shape having a length of about 28 mm in the long axis direction and a length of about 1 mm in the short axis direction.

The optical modulator 22 modulates the shaped beam L32 from the first optical system 21 to form the modulated beam L33 having a pattern in the long axis direction and guides the modulated beam L33 to the second optical system 23. As the optical modulator 22, for example, an LPLV (Liner Planar Light Valve) which is a kind of a PLV (Planar Light Valve) is used.

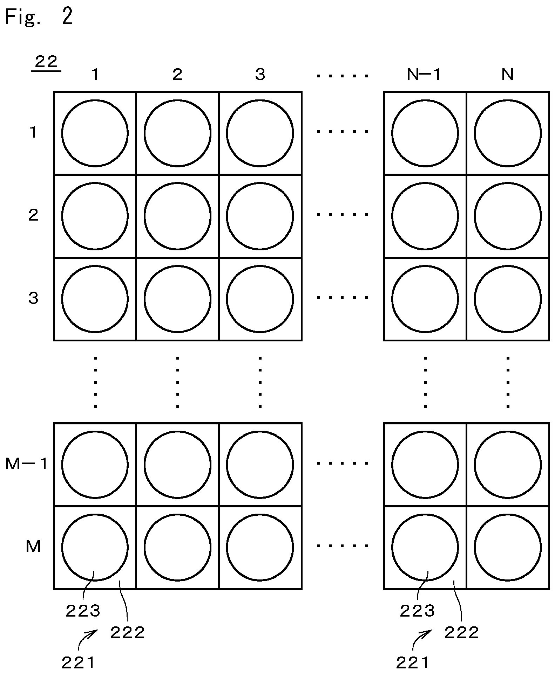

FIG. 2 is a view showing a simplified structure of the optical modulator 22 (i.e., the LPLV). The optical modulator 22 includes a plurality of substantially rectangular pixels 221 which are arranged adjacently in a matrix (i.e., two-dimensionally arranged) on a not-shown substrate. In the optical modulator 22, a surface of the plurality of pixels 221 serves as a modulation surface. In the exemplary case shown in FIG. 2, arranged are M pixels 221 in a longitudinal direction and N pixels 221 in a transverse direction of this figure. The transverse direction in FIG. 2 corresponds to the long axis direction of the shaped beam L32 (see FIG. 1) and the longitudinal direction in FIG. 2 corresponds to the short axis direction of the shaped beam L32.

Each pixel 221 is a modulation element including a fixed member 222 and a movable member 223. The fixed member 222 is a planar and substantially rectangular member fixed to the above-described substrate and provided with a substantially circular opening at its center. The movable member 223 is a substantially circular member provided in the opening of the fixed member 222. On an upper surface of the fixed member 222 (i.e., a plane of this side in a direction perpendicular to this drawing paper in FIG. 2), provided is a fixed reflection surface. On an upper surface of the movable member 223, provided is a movable reflection surface. The movable member 223 is movable in the direction perpendicular to this drawing paper in FIG. 2.

In each pixel 221, by changing a relative position between the fixed member 222 and the movable member 223 in the direction perpendicular to this drawing paper in FIG. 2, a reflected light beam from the pixel 221 is switched between a zero-order beam (i.e., a specularly reflected light beam) and a non-zero-order diffracted beam. In other words, in the pixel 221, when the movable member 223 moves relatively to the fixed member 222, light modulation using a diffraction grating is performed. The zero-order beam generated by the optical modulator 22 is guided to the scanned surface 92 of the modeling material 91 by the second optical system 23 (see FIG. 1). Further, the non-zero-order diffracted beam generated by the optical modulator 22 is blocked by the second optical system 23, not reaching the scanned surface 92 of the modeling material 91. The above-described non-zero-order diffracted beam is mainly a first-order diffracted beam (i.e., a (+1)st order diffracted beam and a (-1)st order diffracted beam) and includes also second or higher-order diffracted beams.

In the optical modulator 22, the reflected light beams from the M pixels 221 (hereinafter, also referred to as a "pixel row") aligned in the longitudinal direction of FIG. 2 are in the same diffraction state. Specifically, when the reflected light beam from one pixel 221 is a zero-order beam, the reflected light beams from all the other pixels 221 (i.e., M-1 pixels 221) in the pixel row including the above one pixel 221 are also the zero-order beams. Further, when the reflected light beam from one pixel 221 is a non-zero-order diffracted beam, the reflected light beams from all the other pixels 221 in the pixel row including the above one pixel 221 are also the non-zero-order diffracted beams. In other words, in the optical modulator 22, no modulation is performed on the shaped beam L32 in the short axis direction and modulation is performed on the shaped beam L32 in the long axis direction.

In the second optical system 23, with respect to N pixel rows aligned in the long axis direction of the shaped beam L32 on the optical modulator 22, the reflected light beams from the M pixels 221 included in each pixel row are integrated and guided to the scanned surface 92 of the modeling material 91, and N spot lights aligned in the long axis direction (i.e., the spot light array extending in the long axis direction) are formed on the scanned surface 92. It is thereby possible to increase the power density of each spot light in the spot light array.

Further, in the optical modulator 22, the M pixels 221 in one pixel row (i.e., M modulation elements) can be regarded also as one modulation element corresponding to one unit space. The optical modulator 22 functions as an optical modulator including N modulation elements aligned in the long axis direction of the shaped beam L32 on the optical modulator 22.

The material feeding mechanism 14 shown in FIG. 1 includes a modeling part 141 and a feeding part 142. The modeling part 141 includes a first cylinder 143 and a first piston 144. The first cylinder 143 is a tubular member extending in an up-and-down direction. The plan-view shape of an internal space of the first cylinder 143 is, for example, a substantially rectangular shape. The first piston 144 is a substantially flat plate-like or substantially columnar member which is accommodated in the internal space of the first cylinder 143, and the plan-view shape thereof is substantially the same as that of the internal space of the first cylinder 143. The first piston 144 is movable in the up-and-down direction inside the internal space of the first cylinder 143. In the modeling part 141, a three-dimensional space surrounded by an inner surface of the first cylinder 143 and an upper surface of the first piston 144 serves as the modeling space 140 in which the three-dimensional modeling is performed by using the modulated beam L33.

The feeding part 142 includes a second cylinder 145, a second piston 146, and a squeegee 147. The second cylinder 145 is a tubular member extending in the up-and-down direction and disposed adjacent to the side of the first cylinder 143. The plan-view shape of an internal space of the second cylinder 145 is, for example, a substantially rectangular shape. The second piston 146 is a substantially flat plate-like or substantially columnar member which is accommodated in the internal space of the second cylinder 145, and the plan-view shape thereof is substantially the same as that of the internal space of the second cylinder 145. The second piston 146 is movable in the up-and-down direction inside the internal space of the second cylinder 145. In the feeding part 142, a three-dimensional space surrounded by an inner surface of the second cylinder 145 and an upper surface of the second piston 146 serves as a storage (pooling) space for storing therein the modeling material 91 which is to be fed to the modeling part 141. The squeegee 147 is a rodlike (e.g., substantially columnar) member extending in a horizontal direction across an upper opening of the second cylinder 145. The squeegee 147 is movable in the horizontal direction along an upper end surface of the second cylinder 145.

In the feeding part 142, the second piston 146 goes up by a predetermined distance and the modeling material 91 inside the second cylinder 145 is thereby lifted upward. Then, the squeegee 147 moves from on the second cylinder 145 to on the first cylinder 143, and the modeling material 91 protruded upward relative to the upper end surface of the second cylinder 145 is thereby fed into the modeling space 140 of the modeling part 141 and held therein. The modeling part 141 is a material holding part for holding the modeling material 91 which is a target object to be irradiated with the modulated beam L33 from the optical apparatus 12. The scanned surface 92 which is an upper surface of the modeling material 91 held inside the modeling space 140 is positioned at a predetermined height (for example, at the same height as that of an upper end surface of the first cylinder 143).

In the three-dimensional modeling apparatus 1, the spot light array formed of the above-described modulated beam L33 is scanned on the modeling material 91 inside the modeling space 140. With this scanning, in the surface layer portion of the modeling material 91 inside the modeling space 140, a portion irradiated with the modulated beam L33 is sintered, to thereby form a portion which corresponds to one layer among a plurality of layers laminated in the up-and-down direction, which are obtained by dividing the three-dimensional model. After the above-described scan of the spot light array on the modeling material 91 inside the modeling space 140 is finished, the first piston 144 goes down by the predetermined distance. After that, as described above, the modeling material 91 is fed into the modeling space 140 from the feeding part 142 and the spot light array is scanned thereon. In the three-dimensional modeling apparatus 1, by repeating the feed of the modeling material 91 into the modeling space 140 and the scan of the spot light array on the modeling material 91 inside the modeling space 140, the three-dimensional model is formed inside the modeling space 140.

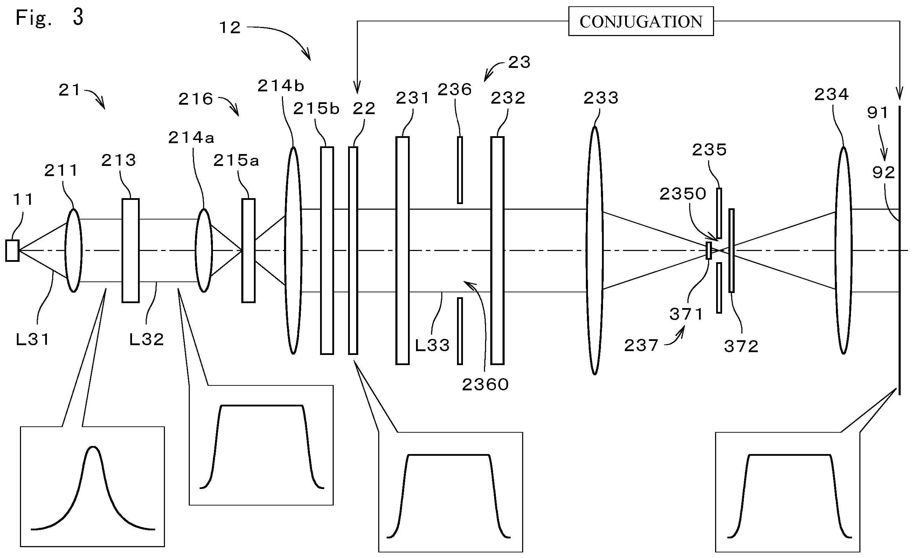

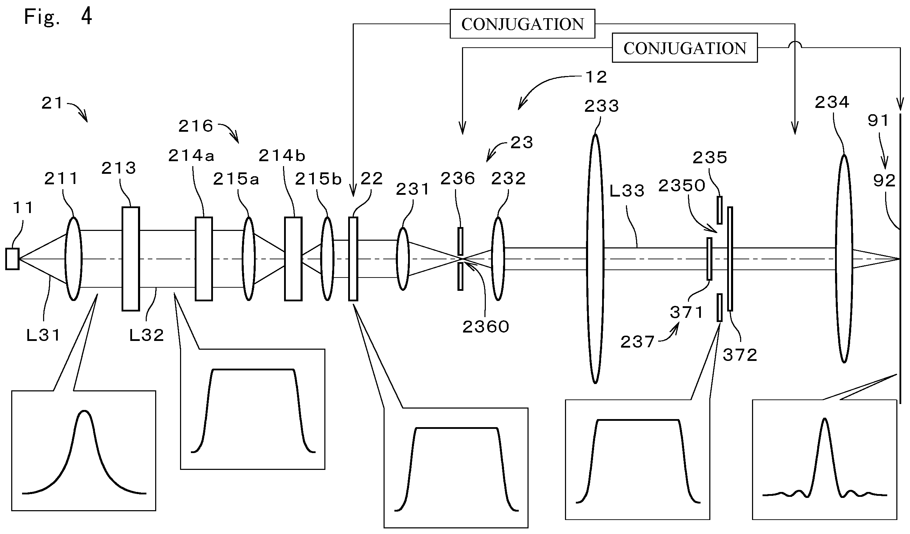

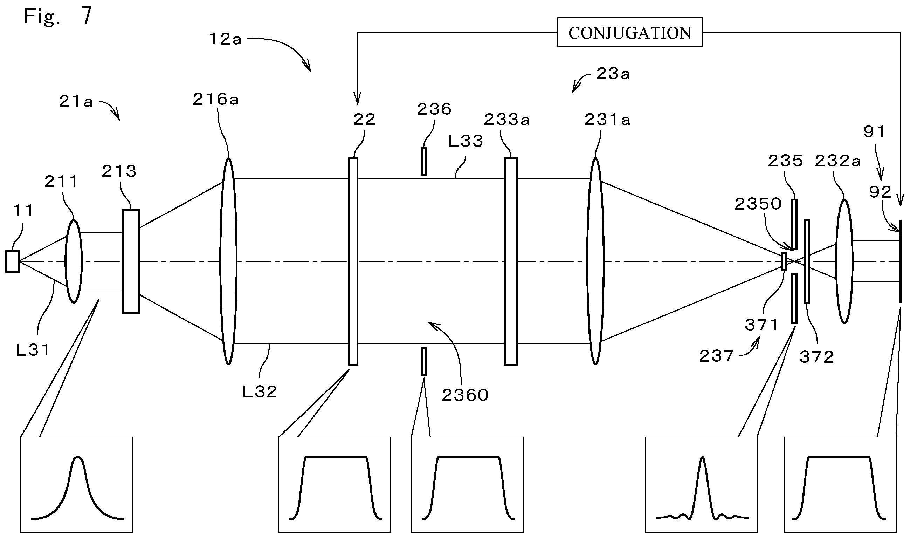

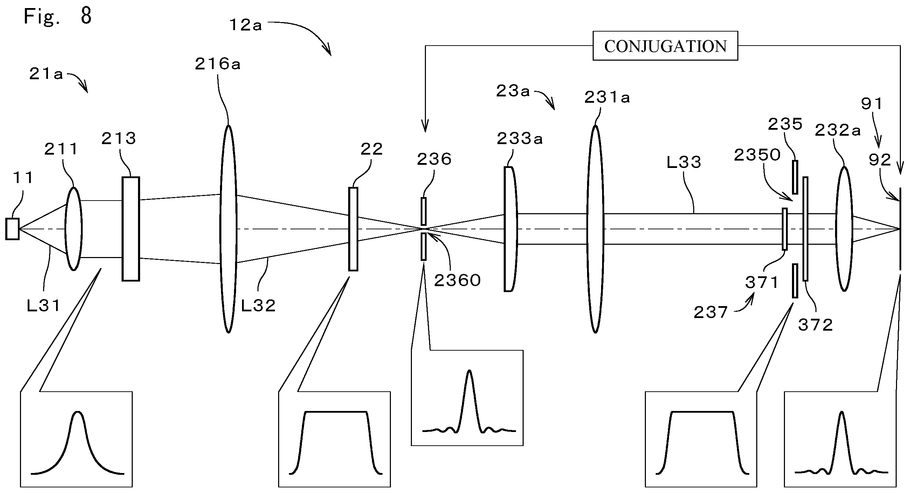

Next, with reference to FIGs. 3 and 4, a detailed configuration of the optical apparatus 12 will be described. FIGs. 3 and 4 are views each schematically showing respective optical paths of the laser beam L31, the shaped beam L32, and the modulated beam L33 in the optical apparatus 12. In the optical apparatus 12 exemplarily shown in FIG. 1, the first optical system 21 and the second optical system 23 are diagonally disposed (i.e., disposed so that an optical axis of the first optical system 21 and an optical axis of the second optical system 23 may be intersected), but in FIGs. 3 and 4, for easy understanding of these figures, the first optical system 21 and the second optical system 23 are shown, with the respective positions thereof (the positional relation) changed, so that the optical axis of the first optical system 21 and the optical axis of the second optical system 23 may be in a straight line. The same applies to FIGs. 7 and 8 described later.

In FIG. 3, the respective optical paths of the shaped beam L32 and the modulated beam L33 are shown so that the short axis direction of the shaped beam L32 and the modulated beam L33 may coincide with the direction perpendicular to this drawing paper. In FIG. 3, the long axis direction of the shaped beam L32 and the modulated beam L33 coincides with the up-and-down direction in this figure. Further, in FIG. 4, the respective optical paths of the shaped beam L32 and the modulated beam L33 are shown so that the long axis direction of the shaped beam L32 and the modulated beam L33 may coincide with the direction perpendicular to this drawing paper. In FIG. 4, the short axis direction of the shaped beam L32 and the modulated beam L33 coincides with the up-and-down direction in this figure. The same applies to FIGs. 7 and 8 described later.

The first optical system 21 of the optical apparatus 12 includes a collimator lens 211, a beam shaper 213, and a beam expander 216. The collimator lens 211, the beam shaper 213, and the beam expander 216 are arranged in this order in the optical axis direction which goes from the laser light source 11 toward the optical modulator 22. The collimator lens 211 generates parallel rays of light from the laser beam L31. The collimator lens 211 may have a spherical shape, an aspherical shape, or a cylindrical shape. Further, in the exemplary case shown in FIGs. 3 and 4, the collimator lens 211 is one lens, but the collimator lens 211 may be constituted of a plurality of lenses.

The beam shaper 213 is a top-hat beam shaper which converts a distribution of light intensity (hereinafter, also referred to simply as an "intensity distribution") on a cross section of a collimated beam entering the beam shaper 213 with a Gaussian distribution, in each of the long axis direction and the short axis direction, from the Gaussian distribution into a top hat distribution in which the width of a region of the maximum intensity is wide (in other words, the top of the region is substantially flat). The beam shaper 213 is, for example, a single optical element. In the present preferred embodiment, the beam shaper 213 is an aspherical concave lens. Further, as the beam shaper 213, any one of various optical elements (for example, a refractive optical element (ROE) such as a freeform lens or the like or a diffractive optical element (DOE)) other than the aspherical concave lens may be used.

The beam expander 216 enlarges a rectangle image generated when the light goes through the beam shaper 213, in the long axis direction and the short axis direction, at different magnifications, to thereby form an image on the modulation surface of the optical modulator 22. The beam expander 216 includes cylinder lenses 214a and 214b for enlarging the above-described rectangle image in the long axis direction. The beam expander 216 includes cylinder lenses 215a and 215b for enlarging the above-described rectangle image in the short axis direction. In the exemplary case shown in FIGs. 3 and 4, in the optical axis direction which goes from the laser light source 11 toward the optical modulator 22, the cylinder lenses 214a, 215a, 214b, and 215b are arranged in this order.

Further, in the first optical system 21, any optical element other than the above lenses may be added. Furthermore, the configuration of the beam expander 216 may be changed in various manners. In the first optical system 21, the beam expander 216 does not always need to be provided but, for example, a beam shaper 213 for directly forming a rectangle image having a desired size on the modulation surface of the optical modulator 22 may be used.

As described above, the first optical system 21 converts the laser beam L31 emitted from the laser light source 11 into the collimated beam and guides the collimated beam to the optical modulator 22. The intensity distribution on the cross section of the laser beam L31 entering the first optical system 21 in each of the long axis direction and the short axis direction is a Gaussian distribution. Though there are some actual cases where this intensity distribution is not an exact Gaussian distribution but is a distribution having a form approximate to the Gaussian function, both the exact Gaussian distribution and the distribution close to the Gaussian distribution are collectively referred to each as a "Gaussian distribution" in the following description.

In the first optical system 21, the laser beam L31 emitted from the laser light source 11 goes through the collimator lens 211, to thereby become the collimated beam which is parallel light (parallel rays of light) in each of the long axis direction and the short axis direction. The collimated beam goes through the beam shaper 213 and the beam expander 216, to be guided to the optical modulator 22. The intensity distribution of the collimated beam before entering the beam shaper 213 is a Gaussian distribution in the long axis direction and a Gaussian distribution also in the short axis direction as shown in a rectangle frame on the lower side of the optical path diagram in each of FIGs. 3 and 4.

When the collimated beam goes through the beam shaper 213, the intensity distribution of the collimated beam in each of the long axis direction and the short axis direction is converted from the Gaussian distribution to the top hat distribution (also referred to as a rectangular distribution), as shown in a rectangle frame on the lower side of the optical path diagram in each of FIGs. 3 and 4. Further, when the collimated beam goes through the beam expander 216, the intensity distribution of the collimated beam in each of the long axis direction and the short axis direction is maintained to be the top hat distribution. Therefore, the intensity distribution of the shaped beam L32 which has passed through the first optical system 21 and enters the optical modulator 22 (i.e., the intensity distribution of the shaped beam L32 on the modulation surface of the optical modulator 22), in each of the long axis direction and the short axis direction, is the top hat distribution.

The second optical system 23 includes a first lens 231, a second lens 232, a third lens 233, a fourth lens 234, a long axis side light shielding part 235, a short axis side light shielding part 236, and a scanning mechanism 237. The first lens 231 and the second lens 232 are each, for example, a cylindrical convex lens. The third lens 233 and the fourth lens 234 are each, for example, a spherical convex lens. The long axis side light shielding part 235 is, for example, a flat plate-like member provided with an opening 2350 having a rectangular shape extending in parallel with the short axis direction, at a center portion thereof. The short axis side light shielding part 236 is, for example, a flat plate-like member provided with an opening 2360 having a rectangular shape extending in parallel with the long axis direction, at a center portion thereof. The material of the long axis side light shielding part 235 and the short axis side light shielding part 236 is, for example, a metal such as stainless steel or the like, ceramics, or the like.

In the present preferred embodiment, the scanning mechanism 237 is a galvano scanner. The scanning mechanism 237 includes a first galvanometer mirror 371, a second galvanometer mirror 372, a first galvano motor (not shown), and a second galvano motor (not shown). The first galvano motor rotates the first galvanometer mirror 371, to thereby change a reflection direction of the modulated beam L33 on the first galvanometer mirror 371. The second galvano motor rotates the second galvanometer mirror 372, to thereby change a reflection direction of the modulated beam L33 on the second galvanometer mirror 372.

The second lens 232 and the third lens 233 are positioned on the side of the scanned surface 92 (in other words, on the side opposite to the optical modulator 22) relative to the first lens 231 in the optical axis direction. In other words, the second lens 232 and the third lens 233 are positioned at a position closer to the scanned surface 92 than the first lens 231 in the optical axis direction. In the exemplary case shown in FIGs. 3 and 4, the third lens 233 is positioned on the side of the scanned surface 92 (in other words, on the side opposite to the first lens 231) relative to the second lens 232 in the optical axis direction. In other words, the second lens 232 is positioned between the first lens 231 and the third lens 233. Further, the third lens 233 may be positioned between the first lens 231 and the second lens 232. The fourth lens 234 is positioned on the side of the scanned surface 92 relative to the first lens 231, the second lens 232, and the third lens 233 in the optical axis direction. In other words, the fourth lens 234 is positioned at a position closer to the scanned surface 92 than the first lens 231, the second lens 232, and the third lens 233 in the optical axis direction.

In the second optical system 23 exemplarily shown in FIGs. 3 and 4, on an optical axis from the optical modulator 22 toward the scanned surface 92, the first lens 231, the short axis side light shielding part 236, the second lens 232, the third lens 233, the long axis side light shielding part 235, and the fourth lens 234 are arranged in this order.

The short axis side light shielding part 236 is disposed in the vicinity of a condensing position on the short axis side of the modulated beam L33 between the first lens 231, and the second lens 232 and the third lens 233. Specifically, assuming that the focal length of the first lens 231 is f₁, the first-order diffraction angle from the optical modulator 22 in the short axis direction is θ1, and an angle (NA) of light entering the short axis side light shielding part 236 to be condensed therein is θ2, it is preferable that the short axis side light shielding part 236 should be disposed within (f₁/2) × (tanθ1/tanθ2) from the condensing position on the optical axis, and it is more preferable that the short axis side light shielding part 236 should be disposed on the condensing position. The short axis side light shielding part 236 is disposed at, for example, a back focus position on the short axis side of the first lens 231.

The long axis side light shielding part 235 is disposed in the vicinity of a condensing position on the long axis side of the modulated beam L33 between the third lens 233 and the fourth lens 234. Specifically, assuming that the focal length of the third lens 233 is f₃, the first-order diffraction angle from the optical modulator 22 in the long axis direction is θ3, and an angle (NA) of light entering the long axis side light shielding part 235 to be condensed therein is θ4, it is preferable that the long axis side light shielding part 235 should be disposed within (f₃/2) × (tanθ3/tanθ4) from the condensing position on the optical axis, and it is more preferable that the long axis side light shielding part 235 should be disposed on the condensing position. The position at which the long axis side light shielding part 235 is disposed is, for example, in the vicinity of a back focus position of the third lens 233.

Further, in the second optical system 23, the scanning mechanism 237 is disposed between the third lens 233 and the fourth lens 234 on the optical axis. The scanning mechanism 237 is disposed in the vicinity of the long axis side light shielding part 235 to be adjacent to the long axis side light shielding part 235. In the optical axis direction, the distance between the scanning mechanism 237 and the long axis side light shielding part 235 is smaller than the distance between the scanning mechanism 237 and the third lens 233 and smaller than the distance between the scanning mechanism 237 and the fourth lens 234.

Specifically, the first galvanometer mirror 371 of the scanning mechanism 237 is disposed on the side of the optical modulator 22 relative to the long axis side light shielding part 235 in the optical axis direction. In other words, the first galvanometer mirror 371 is positioned between the second lens 232 and the third lens 233, and the long axis side light shielding part 235 on the optical axis. In the optical axis direction, the distance between the first galvanometer mirror 371 and the long axis side light shielding part 235 is smaller than the distance between the first galvanometer mirror 371 and the third lens 233 and smaller than the distance between the first galvanometer mirror 371 and the second lens 232. The second galvanometer mirror 372 is disposed on the side of the scanned surface 92 relative to the long axis side light shielding part 235 in the optical axis direction. In other words, the second galvanometer mirror 372 is positioned between the long axis side light shielding part 235 and the fourth lens 234 on the optical axis. In the optical axis direction, the distance between the second galvanometer mirror 372 and the long axis side light shielding part 235 is smaller than the distance between the second galvanometer mirror 372 and the fourth lens 234.

The first galvanometer mirror 371 and the second galvanometer mirror 372 are each disposed in the vicinity of the long axis side light shielding part 235 to be adjacent to the long axis side light shielding part 235. The distance between the first galvanometer mirror 371 and the long axis side light shielding part 235 in the optical axis direction is, for example, 10 mm to 20 mm. The distance between the long axis side light shielding part 235 and the second galvanometer mirror 372 in the optical axis direction is, for example, 10 mm to 20 mm. The distance between the first galvanometer mirror 371 and the long axis side light shielding part 235 in the optical axis direction and the distance between the long axis side light shielding part 235 and the second galvanometer mirror 372 in the optical axis direction may be different from each other but preferably are substantially the same as each other.

In the optical apparatus 12 exemplarily shown in FIGs. 3 and 4, it is preferable that no optical element other than those shown in these figures should be provided. For example, no optical element other than the long axis side light shielding part 235 and the scanning mechanism 237 is disposed between the third lens 233 and the fourth lens 234 on the optical axis. Naturally, no other optical element is disposed between the third lens 233 and the first galvanometer mirror 371 and between the first galvanometer mirror 371 and the long axis side light shielding part 235. Therefore, the modulated beam L33 having passed through the third lens 233 directly (in other words, without passing through any other optical element) enters the first galvanometer mirror 371 and the modulated beam L33 reflected on the first galvanometer mirror 371 directly (in other words, without passing through any other optical element) enters the long axis side light shielding part 235.

Further, no other optical element is also disposed between the long axis side light shielding part 235 and the second galvanometer mirror 372 and between the second galvanometer mirror 372 and the fourth lens 234. Therefore, the modulated beam L33 having passed through the long axis side light shielding part 235 directly (in other words, without passing through any other optical element) enters the second galvanometer mirror 372 and the modulated beam L33 reflected on the second galvanometer mirror 372 directly (in other words, without passing through any other optical element) enters the fourth lens 234.

Further, when the third lens 233 is disposed between the first lens 231 and the second lens 232, it is preferable that no optical element other than the long axis side light shielding part 235 and the scanning mechanism 237 should be disposed between the second lens 232 and the fourth lens 234 on the optical axis.

In the second optical system 23, it is preferable that a front focus position of the first lens 231 (i.e., a focus position on the side of the optical modulator 22) on the short axis side should coincide with the modulation surface of the optical modulator 22. Thus, when the interval (distance) between the optical modulator 22 and the first lens 231 is made not larger than the front focal length of the first lens 231 (preferably, smaller than the front focal length thereof), a focal point distance between a zero-order diffracted beam and a first-order diffracted beam generated after the light passes through the first lens 231 becomes larger. As a result, it is possible to easily separate the zero-order diffracted beam from the non-zero-order diffracted beam such as the first-order diffracted beam or the like.

Further, in the second optical system 23, the front focus position of the third lens 233 coincides with the modulation surface of the optical modulator 22. The back focus position of the first lens 231 (i.e., a focus position on the side of the scanned surface 92) on the short axis side coincides with a front composite focus position of the second lens 232 and the third lens 233 on the short axis side. The back focus position of the third lens 233 coincides with the front focus position of the fourth lens 234. The back focus position of the fourth lens 234 coincides with the scanned surface 92 of the modeling material 91.

In the second optical system 23, the modulation surface of the optical modulator 22 and the scanned surface 92 of the modeling material 91 are optically conjugated with respect to the long axis direction by the third lens 233 and the fourth lens 234. Further, the modulation surface of the optical modulator 22 and the front focus position of the fourth lens 234 are optically conjugated with respect to the short axis direction by the first lens 231, the second lens 232, and the third lens 233. The fourth lens 234 condenses the modulated beam L33 on the scanned surface 92 in the short axis direction. The scanned surface 92 is optically conjugated with the back focus position of the first lens 231 with respect to the short axis direction by the second lens 232, the third lens 233, and the fourth lens 234. In other words, the short axis side light shielding part 236 and the scanned surface 92 are optically conjugated with respect to the short axis direction by the second lens 232, the third lens 233, and the fourth lens 234.

Further, in the second optical system 23, the types of the first lens 231, the second lens 232, the third lens 233, and the fourth lens 234 may be changed in various manners, and any optical element other than those described above may be added. Furthermore, the respective materials, shapes, and structures of the long axis side light shielding part 235 and the short axis side light shielding part 236 may be also changed in various manners.

As described above, the second optical system 23 guides the modulated beam L33 from the optical modulator 22 onto the scanned surface 92 of the modeling material 91, to thereby form a spot light array on the scanned surface 92 and scan the spot light array on the scanned surface 92.

Specifically, the modulated beam L33 which is parallel light (parallel rays of light) generated by the optical modulator 22 passes through the first lens 231, to be thereby condensed at the back focus position of the first lens 231 (i.e., the front composite focus position of the second lens 232 and the third lens 233) in the short axis direction. The modulated beam L33 is not refracted in the long axis direction when it passes through the first lens 231.

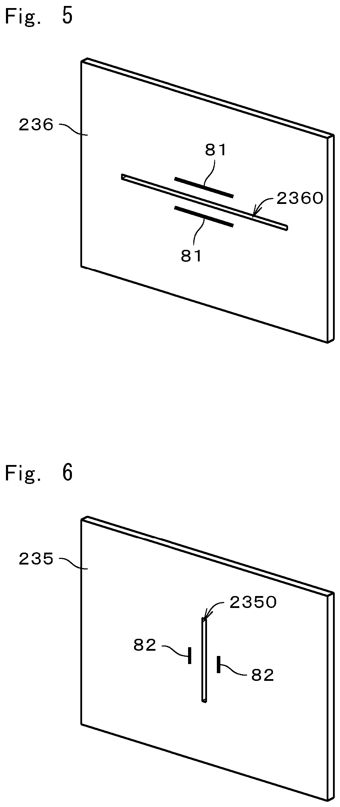

The modulated beam L33 having passed through the first lens 231 goes through the opening 2360 of the short axis side light shielding part 236 positioned at the back focus position on the short axis side of the first lens 231. In detail, out of the reflected light beam reflected on the optical modulator 22, the zero-order beam and the non-zero-order diffracted beam on the long axis side go through the rectangular opening 2360 of the short axis side light shielding part 236. Further, out of the reflected light beam reflected on the optical modulator 22, the non-zero-order diffracted beam on the short axis side (mainly the first-order diffracted beam) is blocked by the short axis side light shielding part 236. As shown in FIG. 5, the non-zero-order diffracted beam on the short axis side is emitted to substantially straight linear irradiation regions 81 extending in the long axis direction at respective portions on the upper side and the lower side of the opening 2360 of the short axis side light shielding part 236 (i.e., both sides of the opening 2360 in the short axis direction).

The cross section of the modulated beam L33 having passed through the opening 2360 of the short axis side light shielding part 236 becomes wider in the short axis direction as the modulated beam L33 goes away from the short axis side light shielding part 236 in the optical axis direction. The modulated beam L33 having passed through the short axis side light shielding part 236 goes through the second lens 232 in the short axis direction, to thereby become parallel light, and the modulated beam L33 is not refracted when the modulated beam L33 goes through the third lens 233. Further, the modulated beam L33 having passed through the short axis side light shielding part 236 may be refracted in the short axis direction when the modulated beam L33 goes through each of the second lens 232 and the third lens 233, to thereby become parallel light at the point in time when the modulated beam L33 goes through the third lens 233. The modulated beam L33 is not refracted in the long axis direction when the modulated beam L33 goes through the second lens 232, and the modulated beam L33 goes through the third lens 233, to be thereby condensed at the back focus position of the third lens 233 (i.e., the front focus position of the fourth lens 234).

The modulated beam L33 having passed through the second lens 232 and the third lens 233 enters the first galvanometer mirror 371 of the scanning mechanism 237. Specifically, out of the modulated beam L33, the zero-order beam enters the first galvanometer mirror 371, and the non-zero-order diffracted beam on the long axis side (mainly, the first-order diffracted beam) does not enter the first galvanometer mirror 371. The zero-order beam of the modulated beam L33 reflected on the first galvanometer mirror 371 goes through the opening 2350 of the long axis side light shielding part 235. In the scanning mechanism 237, the first galvanometer mirror 371 is rotated by the first galvano motor, to thereby change the reflection direction of the zero-order beam on the first galvanometer mirror 371 in the short axis direction. In the long axis side light shielding part 235 disposed at the condensing position of the modulated beam L33 on the long axis side, the position of the zero-order beam passing through the opening 2350 in the short axis direction is thereby changed.

On the other hand, out of the modulated beam L33, the non-zero-order diffracted beam on the long axis side does not enter the first galvanometer mirror 371 as described above and directly enters the long axis side light shielding part 235 and is thereby blocked. As shown in FIG. 6, the non-zero-order diffracted beam on the long axis side is emitted to substantially straight linear irradiation regions 82 extending in the short axis direction at respective portions on the left side and the right side of the opening 2350 of the long axis side light shielding part 235 (i.e., both sides of the opening 2350 in the long axis direction) in this figure.

The cross section of the modulated beam L33 (i.e., the zero-order beam) having passed through the opening 2350 of the long axis side light shielding part 235 becomes wider in the long axis direction as the modulated beam L33 goes away from the long axis side light shielding part 235 in the optical axis direction. The modulated beam L33 having passed through the opening 2350 of the long axis side light shielding part 235 enters the second galvanometer mirror 372 of the scanning mechanism 237. The modulated beam L33 reflected on the second galvanometer mirror 372 enters the fourth lens 234. In the scanning mechanism 237, the second galvanometer mirror 372 is rotated by the second galvano motor, to thereby change the reflection direction of the modulated beam L33 on the second galvanometer mirror 372 in the long axis direction. The position of the modulated beam L33 entering the fourth lens 234 in the long axis direction is thereby changed.

The modulated beam L33 goes through the fourth lens 234, to thereby become parallel light in the long axis direction to be incident onto the scanned surface 92 of the modeling material 91. Further, the modulated beam L33 having entered the fourth lens 234 as the parallel light in the short axis direction goes through the fourth lens 234, to be thereby condensed, in the short axis direction, on the scanned surface 92 positioned at the back focus position of the fourth lens 234.

As described above, the modulation surface of the optical modulator 22 and the scanned surface 92 of the modeling material 91 are optically conjugated with respect to the long axis direction. Further, the intensity distribution of the collimated beam in the long axis direction on the modulation surface of the optical modulator 22 is the top hat distribution as shown in a rectangle frame in FIG. 3. Therefore, the intensity distribution of the modulated beam L33 in the long axis direction on the scanned surface 92 is also the top hat distribution. In other words, an intensity distribution of the spot light array formed of the modulated beam L33 on the scanned surface 92 in the long axis direction is the top hat distribution.

Further, the modulation surface of the optical modulator 22 and the front focus position of the fourth lens 234 (i.e., back focus position of the third lens 233) are optically conjugated with respect to the short axis direction. Furthermore, the intensity distribution of the collimated beam in the short axis direction on the modulation surface of the optical modulator 22 is converted by the beam shaper 213 into the top hat distribution as shown in a rectangle frame in FIG. 4. Therefore, the intensity distribution of the modulated beam L33 having passed through the third lens 233 in the short axis direction is the top hat distribution at the front focus position of the fourth lens 234.

For this reason, the intensity distribution of the modulated beam L33 in the short axis direction at the focal point (i.e., the above-described spot light array) on the scanned surface 92 of the modeling material 91 becomes a distribution of squared sinc function obtained by the Fourier transform action of the fourth lens 234. Though there are some actual cases where the intensity distribution of the modulated beam L33 in the short axis direction is not exactly a distribution of squared sinc function but is a distribution having a form approximate to the squared sinc function, both the distribution of exactly squared sinc function and the distribution which is close to a distribution of squared sinc function are collectively referred to each as a "squared distribution of sinc function" in the following description. Since the squared distribution of sinc function has a main peak, substantially like the Gaussian distribution, the modulated beam L33 can be suitably condensed on the scanned surface 92.

In the three-dimensional modeling apparatus 1, the first galvanometer mirror 371 is rotated in the scanning mechanism 237 of the optical apparatus 12, to thereby scan the above-described spot light array on the scanned surface 92 of the modeling material 91 in a direction corresponding to the short axis direction (i.e., a direction perpendicular to an arrangement direction of the plurality of spot lights in the spot light array). Further, the second galvanometer mirror 372 is rotated in the scanning mechanism 237, to thereby scan the above-described spot light array on the scanned surface 92 of the modeling material 91 in a direction corresponding to the long axis direction (i.e., a direction parallel to the arrangement direction of the plurality of spot lights in the spot light array). In the three-dimensional modeling apparatus 1, by repeating the scan of the spot light array on the modeling material 91 and the feed of the modeling material 91 into the modeling space 140, the three-dimensional model is formed.

The size of the modulated beam L33 on the scanned surface 92 of the modeling material 91 can be obtained as follows. It is assumed, for example, that the wavelength λ of the laser beam L31 is 1.070 µm, and the irradiation region on the modulation surface of the optical modulator 22 has a substantially straight linear shape (or a substantially rectangular shape) where the length L₁ in the long axis direction is 28 mm and the length L₂ in the short axis direction is 1 mm. It is also assumed that the respective focal lengths f₁ and f₂ of the first lens 231 and the second lens 232 on the short axis side are 40 mm and 400 mm and the respective focal lengths f₃ and f₄ of the third lens 233 and the fourth lens 234 are 240 mm and 240 mm. It is further assumed that the distance d between the second lens 232 and the third lens 233 is 50 mm. In this case, the composite focal length f₂₃ of the second lens 232 and the third lens 233 on the short axis side is about 163 mm.

With respect to the short axis direction, as described above, the modulated beam L33 is condensed at the back focus position of the first lens 231 (i.e., the position at which the short axis side light shielding part 236 is disposed). The focus width d_{S1} (i.e., a first dark line width (interval) of the squared distribution of sinc function) of the modulated beam L33 at the back focus position of the first lens 231 in the short axis direction is 2.0×λ×f₁/L₂≈(≒) 86µm. The back focus position of the first lens 231 and the scanned surface 92 of the modeling material 91 are optically conjugated with respect to the short axis direction. Therefore, the focus diameter of the modulated beam L33 on the scanned surface 92 in the short axis direction is 86µm×f₄/f₂₃≈(≒) 126µm.

With respect to the long axis direction, as described above, the modulated beam L33 is condensed at the back focus position of the third lens 233. The focus width d_{L3} (i.e., the first dark line width (interval) of the squared distribution of sinc function) of the modulated beam L33 at the back focus position of the third lens 233 in the long axis direction is 2.0×λ×f₃/L₁≈(≒) 18µm. Further, the length L₃ of the modulated beam L33 at the back focus position of the third lens 233 in the short axis direction is L₂ × f₂₃/f₁ = 4 mm. The modulation surface of the optical modulator 22 and the scanned surface 92 of the modeling material 91 are optically conjugated with respect to the long axis direction. Therefore, the length of the modulated beam L33 on the scanned surface 92 in the long axis direction is L₁ × f₄/f₃ = 28 mm.

As described above, since the short axis side light shielding part 236 is disposed at the back focus position of the first lens 231, the irradiation regions 81 (see FIG. 5) of the first-order diffracted beam (i.e., (+1)st order diffracted beam and (-1)st order diffracted beam) emitted to both the sides of the opening 2360 of the short axis side light shielding part 236 in the short axis direction each have a substantially straight linear shape with L₁ = 28 mm in the long axis direction and d_{S1}≈(≒) 86µm in the short axis direction. Further, since the long axis side light shielding part 235 is disposed at the back focus position of the third lens 233, the irradiation regions 82 (see

FIG. 6) of the first-order diffracted beam emitted to both the sides of the opening 2350 of the long axis side light shielding part 235 in the long axis direction each have a substantially straight linear shape with d_{L3}≈(≒) 18µm in the long axis direction and L₃ = 4 mm in the short axis direction.

On the other hand, in an assumed optical apparatus (hereinafter, referred to as an "optical apparatus of Comparative Example") in which the modulated beam L33 is condensed by one convex lens at the same position (i.e., a back focus position of this convex lens) on the optical path both in the long axis direction and the short axis direction, the first-order diffracted beam is emitted to a point-like irradiation region on a light shielding part disposed at this back focus position. In a case, for example, where the focal length of this convex lens is 240 mm, the diameter of the irradiation region of the first-order diffracted beam on the light shielding part is about 326 µm.

Therefore, in the optical apparatus 12 of the present preferred embodiment, the power density of the first-order diffracted beam on the short axis side light shielding part 236 and the power density of the first-order diffracted beam on the long axis side light shielding part 235 are each reduced to 10 % or less of the power density of the first-order diffracted beam on the light shielding part of the optical apparatus of Comparative Example.

Respective sizes of the first galvanometer mirror 371 and the second galvanometer mirror 372 are changed, depending on the respective positions of the first galvanometer mirror 371 and the second galvanometer mirror 372. It is assumed, for example, that the first galvanometer mirror 371 is disposed on the frontward side (in other words, on the side of the optical modulator 22 in the optical axis direction) by 20 mm from the long axis side light shielding part 235 and the second galvanometer mirror 372 is disposed on the backward side (in other words, on the side of the scanned surface 92 in the optical axis direction) by 20 mm from the long axis side light shielding part 235. In this case, since the irradiation region of the modulated beam L33 on the long axis side light shielding part 235 has a substantially straight linear shape where the length in the long axis direction is 22 µm and the length in the short axis direction is 4 mm and NA forming the modulated beam L33 is about 0.058 on the long axis side and about 0 on the short axis side, the irradiation region of the modulated beam L33 on the first galvanometer mirror 371 and the second galvanometer mirror 372 has a substantially rectangular shape where the length in the long axis direction is about 2.3 mm and the length in the short axis direction is about 4 mm. Therefore, the size of each of the first galvanometer mirror 371 and the second galvanometer mirror 372 is a size within which this irradiation region fits, or larger.

Next, an optical apparatus 12a in accordance with the second preferred embodiment of the present invention will be described, with reference to FIGs. 7 and 8. FIGs, 7 and 8 are views each schematically showing an optical path of the laser beam L31, the shaped beam L32, and the modulated beam L33 in the optical apparatus 12a, and correspond to FIGs. 3 and 4, respectively.

In the optical apparatus 12a shown in FIGs. 7 and 8, instead of the first optical system 21 and the second optical system 23 shown in FIGs. 3 and 4, a first optical system 21a having a configuration different from that of the first optical system 21 and a second optical system 23a having a configuration different from that of the second optical system 23 are provided. Specifically, the first optical system 21a includes an illumination optical element 216a, instead of the beam expander 216 (i.e., the cylinder lenses 214a, 215a, 214b, and 215b) shown in FIGs. 3 and 4. The second optical system 23a includes a first lens 231a, a second lens 232a, and a third lens 233a, instead of the first lens 231, the second lens 232, the third lens 233, and the fourth lens 234 shown in FIGs. 3 and 4. Constituent elements of the optical apparatus 12a other than the above are substantially identical to those of the optical apparatus 12 and represented by the same reference signs as those of the corresponding constituent elements of the optical apparatus 12 in the following description.

The first optical system 21a, substantially like the above-described first optical system 21, shapes the laser beam L31 emitted from the laser light source 11 into the shaped beam L32 having a substantially rectangular shape which is long in the long axis direction and guides the shaped beam L32 to the optical modulator 22. In the first optical system 21a, the collimator lens 211, the beam shaper 213, and the illumination optical element 216a are arranged in this order in the traveling direction (i.e., the optical axis direction) of the light which goes from the laser light source 11 toward the optical modulator 22. The illumination optical element 216a is, for example, a single lens, and in the exemplary case shown in FIGs. 7 and 8, one spherical convex lens. The illumination optical element 216a may be an aspherical convex lens. Further, the illumination optical element 216a may be constituted of a plurality of optical elements.

In the first optical system 21a exemplarily shown in FIGs. 7 and 8, no optical element other than the illumination optical element 216a which is a single lens is disposed between the beam shaper 213 and the optical modulator 22. In other words, the beam emitted from the beam shaper 213 directly (in other words, without passing through any other optical element) enters the illumination optical element 216a. Further, the shaped beam L32 having passed through the illumination optical element 216a directly (in other words, without passing through any other optical element) enters the optical modulator 22.

In the first optical system 21a, substantially like in the first optical system 21, the laser beam L31 emitted from the laser light source 11 goes through the collimator lens 211, to thereby become a collimated beam which is parallel light (parallel rays of light) in each of the long axis direction and the short axis direction. The collimated beam goes through the beam shaper 213 and the illumination optical element 216a, to be guided to the optical modulator 22. The intensity distribution of the collimated beam before entering the beam shaper 213 is a Gaussian distribution in the long axis direction and a Gaussian distribution also in the short axis direction as shown in a rectangle frame on the lower side of the optical path diagram in each of FIGs. 7 and 8.

The beam shaper 213 spreads the collimated beam (i.e., the incident light) incident on the beam shaper 213 at respective different divergence angles in the long axis direction and the short axis direction. After going through the beam shaper 213, the intensity distribution of the collimated beam in each of the long axis direction and the short axis direction is converted from the Gaussian distribution into the top hat distribution (also referred to as a rectangular distribution). Further, when the collimated beam goes through the illumination optical element 216a, the intensity distribution of the collimated beam in each of the long axis direction and the short axis direction is maintained to be the top hat distribution. Therefore, as shown in a rectangle frame on the lower side of the optical path diagram in each of FIGs. 7 and 8, the intensity distribution of the shaped beam L32 which has passed through the first optical system 21a and enters the optical modulator 22 (i.e., the intensity distribution of the shaped beam L32 on the modulation surface of the optical modulator 22), in each of the long axis direction and the short axis direction, is the top hat distribution.

In the first optical system 21a, the above-described collimated beam goes through the beam shaper 213 and the illumination optical element 216a, to thereby become the shaped beam L32 which is parallel light in the long axis direction and convergent light in the short axis direction, to be incident onto the modulation surface of the optical modulator 22. The condensing position of the shaped beam L32 condensed by the illumination optical element 216a in the short axis direction is positioned on the side opposite to the first optical system 21a with the optical modulator 22 interposed therebetween (i.e., on the side of the scanned surface 92 relative to the optical modulator 22). For this reason, the shaped beam L32 enters the optical modulator 22 before reaching the condensing position on the short axis side.

The shaped beam L32 having entered the optical modulator 22 is modulated by the optical modulator 22 and enters the second optical system 23a as the modulated beam L33. The modulated beam L33 entering the second optical system 23a from the optical modulator 22 is parallel light in the long axis direction and convergent light in the short axis direction. The optical modulator 22 is, for example, an LPLV (Liner Planar Light Valve).

The second optical system 23a, substantially like the above-described second optical system 23, is the optical system in which the scanning mechanism 237 for scanning the modulated beam L33 on the scanned surface 92 is incorporated into the projection optical system which guides the modulated beam L33 from the optical modulator 22 onto the scanned surface 92 of the modeling material 91. The second optical systema 23a includes the first lens 231a, the second lens 232a, the third lens 233a, the long axis side light shielding part 235, the short axis side light shielding part 236, and the scanning mechanism 237.

The first lens 231a is, for example, a single lens, and in the exemplary case shown in FIGs. 7 and 8, one spherical convex lens. The second lens 232a is, for example, a single lens, and in the exemplary case shown in FIGs. 7 and 8, one spherical convex lens. Each of the first lens 231a and the second lens 232a may be an aspherical convex lens. The third lens 233a is, for example, a single lens, and in the exemplary case shown in FIGs. 7 and 8, one cylindrical convex lens.

Also in the present preferred embodiment, like in the above-described preferred embodiment, the scanning mechanism 237 is a galvano scanner. In the scanning mechanism 237, the first galvano motor (not shown) rotates the first galvanometer mirror 371, to thereby change the reflection direction of the modulated beam L33 on the first galvanometer mirror 371. Further, the second galvano motor (not shown) rotates the second galvanometer mirror 372, to thereby change the reflection direction of the modulated beam L33 on the second galvanometer mirror 372.

In the second optical system 23a exemplarily shown in FIGs. 7 and 8, on the optical axis from the optical modulator 22 toward the scanned surface 92, the short axis side light shielding part 236, the third lens 233a, the first lens 231a, the long axis side light shielding part 235, and the second lens 232a are arranged in this order.

Like in the above-described second optical system 23, the short axis side light shielding part 236 is disposed in the vicinity of a condensing position on the short axis side of the modulated beam L33 between the optical modulator 22 and the third lens 233a. In the second optical system 23a exemplarily shown in FIGs. 7 and 8, no other optical element such as a lens or the like is disposed between the optical modulator 22 and the short axis side light shielding part 236. In other words, the modulated beam L33 modulated by the optical modulator 22 directly (in other words, without going through any other optical element) enters the short axis side light shielding part 236. Further, the modulated beam L33 having passed through the opening 2360 of the short axis side light shielding part 236 directly (in other words, without going through any other optical element) enters the third lens 233.

Like in the above-described second optical system 23, the long axis side light shielding part 235 is disposed in the vicinity of a condensing position on the long axis side of the modulated beam L33 between the first lens 231a and the second lens 232a. The position at which the long axis side light shielding part 235 is disposed is, for example, in the vicinity of a back focus position of the first lens 231a. The back focus position of the first lens 231a coincides with the front focus position of the second lens 232a.

Further, in the second optical system 23a, the scanning mechanism 237 is disposed between the first lens 231a and the second lens 232a on the optical axis. Like in the above-described second optical system 23, the scanning mechanism 237 is disposed in the vicinity of the long axis side light shielding part 235 to be adjacent to the long axis side light shielding part 235. In the optical axis direction, the distance between the scanning mechanism 237 and the long axis side light shielding part 235 is smaller than the distance between the scanning mechanism 237 and the first lens 231a and smaller than the distance between the scanning mechanism 237 and the second lens 232a.

Specifically, the first galvanometer mirror 371 of the scanning mechanism 237 is disposed on the side of the optical modulator 22 relative to the long axis side light shielding part 235 in the optical axis direction. In other words, the first galvanometer mirror 371 is positioned between the first lens 231a and the long axis side light shielding part 235 on the optical axis. In the optical axis direction, the distance between the first galvanometer mirror 371 and the long axis side light shielding part 235 is smaller than the distance between the first galvanometer mirror 371 and the first lens 231a. The second galvanometer mirror 372 is disposed on the side of the scanned surface 92 relative to the long axis side light shielding part 235 in the optical axis direction. In other words, the second galvanometer mirror 372 is positioned between the long axis side light shielding part 235 and the second lens 232a on the optical axis. In the optical axis direction, the distance between the second galvanometer mirror 372 and the long axis side light shielding part 235 is smaller than the distance between the second galvanometer mirror 372 and the second lens 232a. A positional relation between the first galvanometer mirror 371 and the second galvanometer mirror 372, and the long axis side light shielding part 235 and the like is substantially the same as that in the above-described second optical system 23.

In the second optical system 23a exemplarily shown in FIGs. 7 and 8, it is preferable that no optical element other than those shown in these figures should be provided. For example, no optical element other than the long axis side light shielding part 235 and the scanning mechanism 237 is disposed between the first lens 231a and the second lens 232a on the optical axis. Naturally, no other optical element is disposed between the first lens 231a and the first galvanometer mirror 371 and between the first galvanometer mirror 371 and the long axis side light shielding part 235. Therefore, the modulated beam L33 having passed through the first lens 231a directly (in other words, without passing through any other optical element) enters the first galvanometer mirror 371 and the modulated beam L33 reflected on the first galvanometer mirror 371 directly (in other words, without passing through any other optical element) enters the long axis side light shielding part 235.

Further, no other optical element is also disposed between the long axis side light shielding part 235 and the second galvanometer mirror 372 and between the second galvanometer mirror 372 and the second lens 232a. Therefore, the modulated beam L33 having passed through the long axis side light shielding part 235 directly (in other words, without passing through any other optical element) enters the second galvanometer mirror 372 and the modulated beam L33 reflected on the second galvanometer mirror 372 directly (in other words, without passing through any other optical element) enters the second lens 232a.

In the second optical system 23a, the modulation surface of the optical modulator 22 and the scanned surface 92 of the modeling material 91 are optically conjugated with respect to the long axis direction by the first lens 231a and the second lens 232a. Further, the short axis side light shielding part 236 and the scanned surface 92 are optically conjugated with respect to the short axis direction by the third lens 233a, the first lens 231a, and the second lens 232a. Furthermore, in the second optical system 23a, the types of the first lens 231a, the second lens 232a, and the third lens 233a may be changed in various manners, and any optical element other than those described above may be added.

Like the second optical system 23, the second optical system 23a guides the modulated beam L33 from the optical modulator 22 onto the scanned surface 92 of the modeling material 91, to thereby form the spot light array on the scanned surface 92 and scan the spot light array on the scanned surface 92.

Specifically, the modulated beam L33 which is convergent light on the short axis side is condensed, on the short axis side, at the condensing position at which the short axis side light shielding part 236 is disposed, and goes through the opening 2360 of the short axis side light shielding part 236. In detail, out of the modulated beam L33 which is the reflected light beam reflected on the optical modulator 22, the zero-order beam and the non-zero-order diffracted beam on the long axis side go through the opening 2360 of the short axis side light shielding part 236. The cross section of the modulated beam L33 going through the opening 2360 of the short axis side light shielding part 236 is a substantially straight linear shape or a substantially rectangular shape which is long in the long axis direction. The intensity distribution of the modulated beam L33 going through the opening 2360 of the short axis side light shielding part 236 is substantially a top hat distribution in the long axis direction and a squared distribution of sinc function in the short axis direction as shown in a rectangle frame on the lower side of the optical path diagram in each of FIGs. 7 and 8.

On the other hand, out of the modulated beam L33, the non-zero-order diffracted beam on the short axis side is blocked by the short axis side light shielding part 236. The non-zero-order diffracted beam on the short axis side is emitted to the irradiation regions 81 having a substantially straight linear or substantially rectangular shape which is long in the long axis direction at respective portions on the upper side and the lower side of the opening 2360 of the short axis side light shielding part 236 (i.e., both the sides of the opening 2360 in the short axis direction) shown in FIG. 5.

As shown in FIGs. 7 and 8, the cross section of the modulated beam L33 having passed through the opening 2360 of the short axis side light shielding part 236 becomes wider in the short axis direction as the modulated beam L33 goes away from the short axis side light shielding part 236 in the optical axis direction. The modulated beam L33 having passed through the short axis side light shielding part 236 goes through the third lens 233a and the first lens 231a, to thereby become parallel light in the short axis direction. For example, the modulated beam L33 having passed through the short axis side light shielding part 236 goes through the third lens 233a, to thereby become parallel light in the short axis direction, and the modulated beam L33 is not refracted in the short axis direction when the modulated beam L33 goes through the first lens 231a. Further, the modulated beam L33 is not refracted in the long axis direction when the modulated beam L33 goes through the third lens 233a and goes through the first lens 231a, to be thereby converged and condensed at the back focus position of the first lens 231a (i.e., the front focus position of the second lens 232a).

The modulated beam L33 having passed through the third lens 233a and the first lens 231a enters the first galvanometer mirror 371 of the scanning mechanism 237. Specifically, out of the modulated beam L33, the zero-order beam enters the first galvanometer mirror 371, and the non-zero-order diffracted beam on the long axis side (mainly, the first-order diffracted beam) does not enter the first galvanometer mirror 371. The zero-order beam of the modulated beam L33 reflected on the first galvanometer mirror 371 goes through the opening 2350 of the long axis side light shielding part 235. In the scanning mechanism 237, the first galvanometer mirror 371 is rotated by the first galvano motor, to thereby change the reflection direction of the zero-order beam in the short axis direction on the first galvanometer mirror 371. In the long axis side light shielding part 235 disposed at the condensing position of the modulated beam L33 on the long axis side, the position of the zero-order beam passing through the opening 2350 in the short axis direction is thereby changed.

On the other hand, out of the modulated beam L33, the non-zero-order diffracted beam on the long axis side does not enter the first galvanometer mirror 371 as described above and directly enters the long axis side light shielding part 235 and is thereby blocked. The non-zero-order diffracted beam on the long axis side is emitted to the substantially straight linear irradiation regions 82 extending in the short axis direction at respective portions on the left side and the right side of the opening 2350 of the long axis side light shielding part 235 (i.e., both the sides of the opening 2350 in the long axis direction) shown in FIG. 6.

The cross section of the modulated beam L33 going through the opening 2350 of the long axis side light shielding part 235 is a substantially straight linear shape or a substantially rectangular shape which is long in the short axis direction. The intensity distribution of the modulated beam L33 going through the opening 2350 of the long axis side light shielding part 235 is a squared distribution of sinc function in the long axis direction and a top hat distribution in the short axis direction as shown in a rectangle frame on the lower side of the optical path diagram in each of FIGs. 7 and 8.

The cross section of the modulated beam L33 (i.e., the zero-order beam) having passed through the opening 2350 of the long axis side light shielding part 235 becomes wider in the long axis direction as the modulated beam L33 goes away from the long axis side light shielding part 235 in the optical axis direction. The modulated beam L33 having passed through the opening 2350 of the long axis side light shielding part 235 enters the second galvanometer mirror 372 of the scanning mechanism 237. The modulated beam L33 reflected on the second galvanometer mirror 372 enters the second lens 232a. In the scanning mechanism 237, the second galvanometer mirror 372 is rotated by the second galvano motor, to thereby change the reflection direction of the modulated beam L33 in the long axis direction on the second galvanometer mirror 372. The position of the modulated beam L33 entering the second lens 232a in the long axis direction is thereby changed.

The modulated beam L33 goes through the second lens 232a, to thereby become parallel light in the long axis direction to be incident onto the scanned surface 92 of the modeling material 91. Further, the modulated beam L33 having entered the third lens 232a as the parallel light in the short axis direction goes through the second lens 232a, to be thereby condensed, in the short axis direction, on the scanned surface 92 positioned at the back focus position of the second lens 232a.

The cross section of the modulated beam L33 on the scanned surface 92 of the modeling material 91 is a substantially rectangular shape which is long in the long axis direction. The intensity distribution of the modulated beam L33 on the scanned surface 92 is a top hat distribution in the long axis direction and a squared distribution of sinc function in the short axis direction as shown in a rectangle frame on the lower side of the optical path diagram in each of FIGs. 7 and 8. In other words, the intensity distribution of the spot light array formed of the modulated beam L33 on the scanned surface 92 in the long axis direction and the intensity distribution thereof in the short axis direction is a top hat distribution and a squared distribution of sinc function, respectively. It is thereby possible to suitably condense the modulated beam L33 on the scanned surface 92.

In the three-dimensional modeling apparatus 1 including the optical apparatus 12a, substantially like in the above-described three-dimensional modeling apparatus 1, the first galvanometer mirror 371 is rotated in the scanning mechanism 237 of the optical apparatus 12a, to thereby scan the above-described spot light array on the scanned surface 92 of the modeling material 91 in a direction corresponding to the short axis direction (i.e., a direction perpendicular to the arrangement direction of the plurality of spot lights in the spot light array). Further, the second galvanometer mirror 372 is rotated in the scanning mechanism 237, to thereby scan the above-described spot light array on the scanned surface 92 of the modeling material 91 in a direction corresponding to the long axis direction (i.e., a direction parallel to the arrangement direction of the plurality of spot lights in the spot light array). In the three-dimensional modeling apparatus 1, by repeating the scan of the spot light array on the modeling material 91 and the feed of the modeling material 91 into the modeling space 140, the three-dimensional model is formed.

In the above-described optical apparatus 12, 12a, when the optical element disposed between the short axis side light shielding part 236 and the scanned surface 92 of the modeling material 91, for condensing the modulated beam L33 in the long axis direction, is referred to as a "first projection optical element", the third lens 233 is the first projection optical element in the optical apparatus 12, and the first lens 231a is the first projection optical element in the optical apparatus 12a. Further, when the optical element disposed between the long axis side light shielding part 235 and the scanned surface 92, for converging the modulated beam L33 having passed through the long axis side light shielding part 235 in the short axis direction and condensing this modulated beam L33 on the scanned surface 92, is referred to as a "second projection optical element", the fourth lens 234 is the second projection optical element in the optical apparatus 12, and the second lens 232a is the second projection optical element in the optical apparatus 12a.

Though the first galvanometer mirror 371 is rotated, to thereby change the reflection direction of the modulated beam L33 in the short axis direction and the second galvanometer mirror 372 is rotated, to thereby change the reflection direction of the modulated beam L33 in the long axis direction in the above-described optical apparatus 12, 12a, this is only one example. There may be a case, for example, where the first galvanometer mirror 371 is rotated, to thereby change the reflection direction of the modulated beam L33 in the long axis direction and the second galvanometer mirror 372 is rotated, to thereby change the reflection direction of the modulated beam L33 in the short axis direction. In other words, the first galvanometer mirror 371 is rotated, to thereby change the reflection direction of the modulated beam L33 in either one of the long axis direction and the short axis direction. Further, the second galvanometer mirror 372 is rotated, to thereby change the reflection direction of the modulated beam L33 in the other one of the long axis direction and the short axis direction.

Though the first galvanometer mirror 371 is disposed between the first projection optical element (i.e., the third lens 233 / the first lens 231a) and the long axis side light shielding part 235 and the second galvanometer mirror 372 is disposed between the long axis side light shielding part 235 and the second projection optical element (i.e., the fourth lens 234 / the second lens 232a) in the above-described optical apparatus 12, 12a, this is only one example. For example, the first galvanometer mirror 371 and the second galvanometer mirror 372 may be disposed between the long axis side light shielding part 235 and the above-described second projection optical element. In this case, since there is no mechanism for changing the direction (orientation) of the modulated beam L33 toward the side of the optical modulator 22 relative to the long axis side light shielding part 235 in the optical axis direction, it is possible to reduce the size of the opening 2350 of the long axis side light shielding part 235. Further, since the non-zero-order diffracted beam on the long axis side does not enter the galvanometer mirror, it is possible to facilitate the design of the scanning mechanism 237 and the long axis side light shielding part 235.

Alternatively, the first galvanometer mirror 371 and the second galvanometer mirror 372 may be disposed between the above-described first projection optical element and the long axis side light shielding part 235. Thus, by arranging the first galvanometer mirror 371 and the second galvanometer mirror 372 on either one side relative to the long axis side light shielding part 235 in the optical axis direction, it is possible to reduce the distance between the first galvanometer mirror 371 and the second galvanometer mirror 372 in the optical axis direction. As a result, it is possible to downsize the second galvanometer mirror 372 which needs to receive the modulated beam L33 whose reflection direction is changed by the first galvanometer mirror 371.

It is preferable that the arrangement of the first galvanometer mirror 371 and the second galvanometer mirror 372 should be determined so that the shape of the irradiation region of the modulated beam L33 on the scanned surface 92 of the modeling material 91 can be made closer to a desired shape, in consideration of the distortion characteristics due to the arrangement, the distortion characteristics of the above-described second projection optical element, and the like.

In the above-described optical apparatus 12, 12a, the scanning mechanism 237 may include only either one of the first galvanometer mirror 371 and the second galvanometer mirror 372. The one galvanometer mirror may be disposed on the side of the optical modulator 22 relative to the long axis side light shielding part 235 or on the side of the scanned surface 92 relative to the long axis side light shielding part 235 in the optical axis direction. Further, the reflection direction of the modulated beam L33 which is changed by rotating the one galvanometer mirror may be in the long axis direction or in the short axis direction.

Specifically, in the case where the one galvanometer mirror is disposed on the side of the optical modulator 22 relative to the long axis side light shielding part 235 in the optical axis direction, by rotating the one galvanometer mirror, the modulated beam L33 before entering the long axis side light shielding part 235 is scanned in one of the long axis direction and the short axis direction. Further, in the case where the one galvanometer mirror is disposed on the side of the scanned surface 92 relative to the long axis side light shielding part 235 in the optical axis direction, by rotating the one galvanometer mirror, the modulated beam L33 having passed through the long axis side light shielding part 235 is scanned in one of the long axis direction and the short axis direction. Then, the scan of the modulated beam L33 in the other one of the long axis direction and the short axis direction is performed, for example, when a moving mechanism such as a linear motor or the like provided in the material feeding mechanism 14 moves the modeling material 91 inside the modeling space 140 in a direction corresponding to the other direction.

As described above, the optical apparatus 12, 12a is an apparatus for emitting a spot light array onto a target object (the modeling material 91 in the above-described exemplary case) and scanning the spot light array thereon. The optical apparatus 12, 12a includes the first optical system 21, 21a, the optical modulator 22, and the second optical system 23, 23a. The first optical system 21, 21a shapes the laser beam L31 into the shaped beam L32 which is long in the long axis direction. The optical modulator 22 modulates the shaped beam L32, to thereby form the modulated beam L33 having a pattern in the long axis direction. The second optical system 23, 23a guides the modulated beam L33 to the scanned surface 92 of the target object, to thereby form the spot light array extending in the long axis direction on the scanned surface 92 and scan the spot light array on the scanned surface 92.

The second optical system 23, 23a includes the short axis side light shielding part 236, the first projection optical element (the third lens 233 or the first lens 231a in the above-described exemplary case), the long axis side light shielding part 235, the second projection optical element (the fourth lens 234 or the second lens 232a in the above-described exemplary case), and the scanning mechanism 237.

The short axis side light shielding part 236 is disposed at the condensing position on the short axis side of the modulated beam L33. The short axis side light shielding part 236 blocks the non-zero-order diffracted beam on the short axis side of the modulated beam L33. The first projection optical element is disposed between the short axis side light shielding part 236 and the scanned surface 92. The first projection optical element condenses the modulated beam L33 in the long axis direction. The long axis side light shielding part 235 is disposed at the condensing position on the long axis side of the modulated beam L33 by the first projection optical element between the first projection optical element and the scanned surface 92. The long axis side light shielding part 235 blocks the non-zero-order diffracted beam on the long axis side of the modulated beam L33. The second projection optical element is disposed between the long axis side light shielding part 235 and the scanned surface 92. The second projection optical element converges the modulated beam L33 having passed through the long axis side light shielding part 235 in the short axis direction and condenses the modulated beam L33 onto the scanned surface 92, to thereby form the spot light array on the scanned surface 92.

The scanning mechanism 237 is disposed between the first projection optical element and the second projection optical element, to be adjacent to the long axis side light shielding part 235. The scanning mechanism 237 scans the modulated beam L33 before entering the long axis side light shielding part 235 or the modulated beam L33 having passed through the long axis side light shielding part 235 in at least one of the long axis direction and the short axis direction. In the optical apparatus 12, 12a, the modulation surface of the optical modulator 22 and the scanned surface 92 are optically conjugated with respect to the long axis direction by the second optical system 23, 23a.

Thus, in the second optical system 23, 23a of the optical apparatus 12, 12a, inside the projection optical system for relaying the modulated beam L33 from the optical modulator 22 to the target object and forming the spot light array on the scanned surface 92, the scanning mechanism 237 for scanning the spot light array on the scanned surface 92 is incorporated. For this reason, it is possible to omit the optical elements (for example, the collimator lens, the Fθ lens, and the like provided in front of and behind the galvano scanner in the scanning part) other than the scanning mechanism, which are needed in the scanning part in a case where the projection optical system and the scanning part are provided separately. As a result, it is possible to simplify the structure of the optical apparatus 12, 12a. Further, the optical apparatus 12, 12a can be downsized. Furthermore, it is also possible to reduce the manufacturing cost of the optical apparatus 12, 12a.

As described above, it is preferable that the scanning mechanism 237 should be a galvano scanner which changes the reflection direction of the modulated beam L33. It is thereby possible to perform the scan of the spot light array on the scanned surface 92 with a simple structure. As a result, it is possible to further simplify the structure of the optical apparatus 12, 12a.

As described above, it is preferable that the galvano scanner should include the first galvanometer mirror 371 and the second galvanometer mirror 372. It is preferable that the first galvanometer mirror 371 should be disposed between the first projection optical element and the long axis side light shielding part 235, to be adjacent to the long axis side light shielding part 235. By being rotated, the first galvanometer mirror 371 changes the reflection direction of the modulated beam L33 in one of the long axis direction and the short axis direction. Further, it is preferable that the second galvanometer mirror 372 should be disposed between the long axis side light shielding part 235 and the second projection optical element, to be adjacent to the long axis side light shielding part 235. By being rotated, the second galvanometer mirror 372 changes the reflection direction of the modulated beam L33 in the other one of the long axis direction and the short axis direction.

Thus, in the optical axis direction, by arranging the first galvanometer mirror 371 and the second galvanometer mirror 372 on the front and back sides of the long axis side light shielding part 235, respectively, it is possible to make the distance between the first projection optical element and the long axis side light shielding part 235 and the distance between the long axis side light shielding part 235 and the second projection optical element substantially the same as each other. In other words, it is possible to make the distance between the condensing position on the long axis side of the modulated beam L33 and the first projection optical element and the distance between the condensing position on the long axis side of the modulated beam L33 and the second projection optical element substantially the same as each other in the optical axis direction. It is thereby possible to improve the distortion characteristics of the optical apparatus 12, 12a.

As described above, it is preferable that the first galvanometer mirror 371 should change the reflection direction in the short axis direction of the modulated beam L33. It is thereby possible to reduce the width of the opening 2350 in the long axis direction (in other words, the width thereof in the left-and-right direction in FIG. 6) in the long axis side light shielding part 235. As a result, it is possible to suppress the non-zero-order diffracted beam on the long axis side from entering the opening 2350 and perform modulation of the spot light array by the optical modulator 22 with high accuracy.

As described above, it is preferable that the first optical system 21, 21a should include the beam shaper 213. It is preferable that the beam shaper 213 should convert the intensity distribution of the laser beam L31 in the long axis direction from the Gaussian distribution, to thereby bring the intensity distribution of the shaped beam L32 on the modulation surface in the long axis direction into the top hat distribution. It is thereby possible to increase the total amount of light to be inputted to the optical modulator 22 while reducing the maximum power density of the shaped beam L32 to be incident onto the optical modulator 22. Therefore, it is possible to increase the amount of light to be inputted to the optical modulator 22 while reducing a damage risk of the optical modulator 22. As a result, it is possible to suitably increase the power density of the modulated beam L33 to be emitted to the target object.

As described above, it is preferable that the beam shaper 213 should convert the intensity distribution of the laser beam L31 in the short axis direction from the Gaussian distribution, to thereby bring the intensity distribution of the shaped beam L32 on the modulation surface in the short axis direction into the top hat distribution. It is thereby possible to increase the total amount of light to be inputted to the optical modulator 22 while further reducing the maximum power density of the shaped beam L32 to be incident onto the optical modulator 22.

As described above, it is preferable that no optical element is disposed between the scanning mechanism 237 and the long axis side light shielding part 235. It is thereby possible to further simplify the structure of the optical apparatus 12, 12a.

As described above, it is preferable that the optical modulator 22 should be a PLV (Planar Light Valve). Since the PLV has high power resistance performance, the PLV is especially suitable for the optical modulator 22 which is required to increase the amount of light to be inputted thereto.

The above-described three-dimensional modeling apparatus 1 includes the optical apparatus 12 or 12a, the laser light source 11, and the material holding part (the modeling part 141 in the above-described exemplary case). The laser light source 11 emits the laser beam L31 to the optical apparatus 12, 12a. The material holding part holds the modeling material 91 which is the above-described target object to which the modulated beam L33 from the optical apparatus 12, 12a is emitted. In the three-dimensional modeling apparatus 1, as described above, it is possible to simplify the structure of the optical apparatus 12, 12a. Therefore, it is possible to simplify the structure of the three-dimensional modeling apparatus 1 and reduce the size thereof.

In the optical apparatus 12, 12a and three-dimensional modeling apparatus 1 described above, various modifications can be made.

For example, the optical modulator 22 is not necessarily limited to the LPLV but may be a PLV other than the LPLV. Further, as the optical modulator 22, any one other than the PLV, such as a GLV (Grating Light Valve) (registered trademark), a DMD (Digital Micromirror Device), or the like can be also used.

The scanning mechanism 237 does not necessarily need to be the galvano scanner but may be a scanning mechanism having any other configuration, such as a polygon laser scanner or the like.

In the optical apparatus 12, 12a, the beam shaper 213 does not necessarily need to be a single optical element but may be formed of a plurality of optical elements. The beam shaper 213 may not convert the intensity distribution of the laser beam L31 in the short axis direction into the top hat distribution but convert only the intensity distribution of the laser beam L31 in the long axis direction into the top hat distribution. Alternatively, in the optical apparatus 12, 12a, the beam shaper 213 for converting the intensity distribution of the laser beam L31 into the top hat distribution may be omitted.

In the optical apparatus 12, 12a, any other optical element may be disposed between the scanning mechanism 237 and the long axis side light shielding part 235.

The optical apparatus 12, 12a may be provided in a three-dimensional modeling apparatus having a configuration different from that of the above-described three-dimensional modeling apparatus 1. Further, the optical apparatus 12, 12a does not necessarily need to be provided in the three-dimensional modeling apparatus 1 but may be used in any of various apparatuses (for example, a laser beam machine such as a laser marking apparatus, a laser drilling apparatus, or the like) other than the three-dimensional modeling apparatus.

The configurations in the above-described preferred embodiment and variations may be combined as appropriate only if those do not conflict with one another.

While the invention has been shown and described in detail, the foregoing description is in all aspects illustrative and not restrictive. It is therefore understood that numerous modifications and variations can be devised without departing from the scope of the invention.

### REFERENCE SIGNS LIST

- 1: Three-dimensional modeling apparatus
- 11: Laser light source
- 12, 12a: Optical apparatus
- 21, 21a: First optical system
- 22: Optical modulator
- 23, 23a: Second optical system
- 91: Modeling material
- 92: Scanned surface
- 141: Modeling part
- 213: Beam shaper
- 231, 231a: First lens
- 232, 232a: Second lens
- 233, 233a: Third lens
- 234: Fourth lens
- 235: Long axis side light shielding part
- 236: Short axis side light shielding part
- 237: Scanning mechanism
- 371: First galvanometer mirror
- 372: Second galvanometer mirror
- L31: Laser beam
- L32: Shaped beam
- L33: Modulated beam

## Claims

1. An optical apparatus for emitting a spot light array onto a target object to scan said spot light array thereon, comprising:
a first optical system for shaping a laser beam into a shaped beam which is long in a long axis direction;
an optical modulator for modulating said shaped beam into a modulated beam having a pattern in said long axis direction; and
a second optical system for guiding said modulated beam onto a scanned surface of a target object, to thereby form a spot light array extending in said long axis direction on said scanned surface and scan said spot light array on said scanned surface,
wherein said second optical system comprises:
a short axis side light shielding part disposed at a condensing position on a short axis side of said modulated beam, for blocking a non-zero-order diffracted beam on said short axis side of said modulated beam;
a first projection optical element disposed between said short axis side light shielding part and said scanned surface, for condensing said modulated beam in said long axis direction;
a long axis side light shielding part disposed at a condensing position on a long axis side of said modulated beam from said first projection optical element, between said first projection optical element and said scanned surface, for blocking a non-zero-order diffracted beam on said long axis side of said modulated beam;
a second projection optical element disposed between said long axis side light shielding part and said scanned surface, for converging said modulated beam having passed through said long axis side light shielding part in said short axis direction and condensing said modulated beam on said scanned surface, to thereby form a spot light array on said scanned surface; and
a scanning mechanism disposed between said first projection optical element and said second projection optical element, to be adjacent to said long axis side light shielding part, for scanning said modulated beam before entering said long axis side light shielding part or said modulated beam having passed through said long axis side light shielding part in at least one of said long axis direction and said short axis direction,
a modulation surface of said optical modulator and said scanned surface are optically conjugated with respect to said long axis direction by said second optical system.

2. The optical apparatus according to claim 1, wherein
said scanning mechanism is a galvano scanner for changing a reflection direction of said modulated beam.

3. The optical apparatus according to claim 2, wherein
said galvano scanner comprises:
a first galvanometer mirror disposed between said first projection optical element and said long axis side light shielding part to be adjacent to said long axis side light shielding part, for being rotated, to thereby change a reflection direction of said modulated beam in either one of said long axis direction and said short axis direction; and
a second galvanometer mirror disposed between said long axis side light shielding part and said second projection optical element to be adjacent to said long axis side light shielding part, for being rotated, to thereby change a reflection direction of said modulated beam in the other one of said long axis direction and said short axis direction.

4. The optical apparatus according to claim 3, wherein
said first galvanometer mirror changes a reflection direction of said modulated beam in said short axis direction.

5. The optical apparatus according to claim 1, wherein
said first optical system comprises:
a beam shaper for converting an intensity distribution of said laser beam in said long axis direction from a Gaussian distribution, to thereby bring an intensity distribution of said shaped beam on said modulation surface in said long axis direction into a top hat distribution.

6. The optical apparatus according to claim 5, wherein
said beam shaper converts an intensity distribution of said laser beam in said short axis direction from a Gaussian distribution, to thereby also bring an intensity distribution of said shaped beam on said modulation surface in said short axis direction into a top hat distribution.

7. The optical apparatus according to claim 1, wherein
no optical element is disposed between said scanning mechanism and said long axis side light shielding part.

8. The optical apparatus according to claim 1, wherein
said optical modulator is a PLV (Planar Light Valve).

9. A three-dimensional modeling apparatus, comprising:
said optical apparatus according to any one of claims 1 to 8;
a laser light source for emitting said laser beam to said optical apparatus; and
a material holding part for holding a modeling material which is said target object to be irradiated with said modulated beam from said optical apparatus.
